# EUROPÄISCHE PATENTSCHRIFT

(11) **EP 1 264 403 B1**
(45) Veröffentlichungstag und Bekanntmachung des Hinweises auf die Patenterteilung: **17.10.2007**
(21) Anmeldenummer: 01909779.9
(22) Anmeldetag: 20.02.2001
(51) Int. Cl.: H03K 17/945

(54) **NÄHERUNGSSENSOR UND BAUKASTENSYSTEM ZUR BILDUNG VON NÄHERUNGSSENSOREN**
PROXIMITY SENSOR AND MODULAR SYSTEM FOR PRODUCING PROXIMITY SENSORS
DETECTEUR DE PROXIMITE ET SYSTEME DE BLOCS-ELEMENTS POUR PRODUIRE DES DETECTEURS DE PROXIMITE

(30) Priorität: 02.03.2000 DE 10010094; 06.07.2000 DE 10032864
(43) Veröffentlichungstag der Anmeldung: 11.12.2002
(73) Patentinhaber: ABB RESEARCH LTD., 8050 Zürich (CH)
(72) Erfinder: SCHEIBLE, Guntram, 69493 Hirschberg (DE)
(74) Vertreter: Miller, Toivo
(86) Internationale Anmeldenummer: PCT/EP2001/001865
(87) Internationale Veröffentlichungsnummer: WO 2001/065694

(56) Entgegenhaltungen:
- DE-A- 2 819 782
- DE-A- 3 907 285
- DE-A- 4 016 400
- DE-A- 4 017 232
- DE-A- 19 755 924
- FR-A- 2 694 414
- US-A- 3 719 898
- US-A- 4 757 213
- US-A- 5 218 311

## Beschreibung

Die Erfindung bezieht sich auf einen Näherungssensor gemäß dem Oberbegriff des Anspruchs 1 sowie auf ein Baukastensystem zur Bildung von Näherungssensoren.

Ein Näherungssensor ist beispielsweise aus der DE 33 18 900 A1 bekannt. Beim bekannten Näherungssensor wird bereits ein Minisender eingesetzt, der das Sensorsignal drahtlos an eine andere Einheit weiterleitet.

Es ist allgemein bekannt, Näherungssensoren mit unterschiedlicher äußerer Formgebung herzustellen, beispielsweise mit zylindrischem Gehäuse mit einem Durchmesser von 4, 6, 8, 12, 18 und 30 mm oder auch mit kubusförmigem Gehäuse (siehe hierzu beispielsweise ABB Catalog Nr. 1SAC103699L0201, gedruckt 6/99, Seiten VI und VII). Die äußere Formgebung des Gehäuses korrespondiert mit den in Maschinenkomponenten vorzusehenden Befestigungsöffnungen. Oft wird bei zylindrischen Gehäusen der Gehäuse-Durchmesser in Abhängigkeit des Sensor-Abstandes gewählt. Dabei ist es insbesondere bei sehr kleinen Durchmessern des Gehäuses schwierig, außer dem Sensorkopf mit Sensorspule und einer Sensorsignal-Auswerteeinheit zusätzliche elektronische Einheiten, wie Funksender, Funkempfänger und Antenne innerhalb des Gehäuses unterzubringen.

Der Erfindung liegt die Aufgabe zugrunde, einen Näherungssensor der eingangs genannten Art anzugeben, der in einfacher Weise an unterschiedlich dimensionierte Befestigungsöffnungen angepaßt werden kann.

Des weiteren soll ein Baukastensystem zur Bildung von Näherungssensoren angegeben werden.

Diese Aufgabe wird hinsichtlich des Näherungssensors in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß der als eigene Baukomponente ausgebildete Elektronikabschnitt des Näherungssensors universell für alle Varianten der als eigene Baukomponenten ausgebildeten Befestigungsabschnitte (mit unterschiedlichen Gehäuse-Durchmessem oder unterschiedlichen Gehäuse-Ausführungen) verwendbar ist. Die Elektronik des Näherungssensors inklusive Sensorsignal-Auswerteeinheit, Funksender, Antenne und kabellose Energieversorgung muß nicht derart miniaturisiert werden, um auch noch in Befestigungsabschnitte mit äußerst geringen Dimensionen zu passen (siehe beispielsweise Näherungssensoren mit zylindrischem Gehäuse von 4 oder 6 mm Durchmesser). Das Baukastensystem ermöglicht die kostengünstige Herstellung von Näherungssensoren mit unterschiedlichen, jeweils an die Befestigungsöffnungen von Maschinenkomponenten angepaßten Befestigungsabschnitten, wobei jeweils gleiche Elektronikabschnitte für unterschiedliche Befestigungsabschnitte einsetzbar sind.

Weitere Vorteile sind aus der nachstehenden Beschreibung ersichtlich.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Fig.1: eine erste Ausführungsform eines steckbaren Näherungssensors,
- Fig. 2: eine zweite Ausführungsform eines steckbaren Näherungssensors,
- Fig. 3: eine dritte Ausführungsform eines steckbaren Näherungssensors.

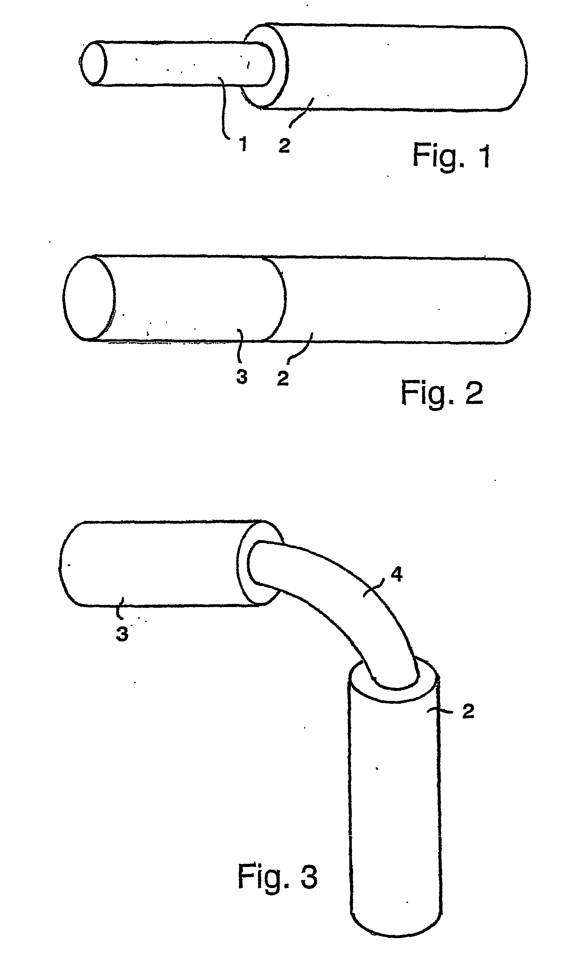

In Fig. 1 ist eine erste Ausführungsform eines steckbaren Näherungssensors dargestellt. Der Näherungssensor ist aus zwei miteinander verbindbaren Baukomponenten, nämlich einem Befestigungsabschnitt 1 und einem Elektronikabschnitt 2 zusammengesetzt. Der vorzugsweise aus Metall bestehende zylinderförmige Befestigungsabschnitt 1 dient zur Befestigung des eine Sensorumgebung detektierenden Sensorkopfes in einer Bohrung bzw. allgemein einer Befestigungsöffnung einer Maschinenkomponente und ist hierzu vorzugsweise mit einem Gewinde versehen. Der Befestigungsabschnitt 1 enthält im Falle eines induktiven Näherungssensors eine Sensorspule und gegebenenfalls einen Resonanzkondensator.

Der vorzugsweise mit einem Kunststoffgehäuse versehene Elektronikabschnitt 2 enthält eine zur Auswertung des Sensorsignales erforderliche Sensorsignal-Auswerteeinheit, einen zur Umwandlung des ausgewerteten Sensorsignales erforderlichen Modulator/Codierer und einen zur Abstrahlung von Funksignalen dienenden Sender mit Antenne (allgemein Mittel zur Funkübertragung an eine entfernte Einrichtung). Zweckmäßig enthält der Elektronikabschnitt 2 darüber hinaus einen Funkempfänger zum Empfang von Parametersätzen (Sensor-Schaltschwellen, Schalthysteresen, Korrekturfaktoren für unterschiedliche zu identifizierende Materialien, vorgegebene Entfemungsbereiche zwischen Sensor und zu identifizierendem Objekt) und einen nachgeschalteten Demodulator/Decodierer zur Aufbereitung des empfangenen Signals und Speicherung sowie Zufuhr zur Sensorsignal-Auswerteeinheit. Des weiteren enthält der Elektronikabschnitt 2 eine zur kabellosen Energieeinspeisung und -versorgung erforderliche Einheit.

Diese Energieversorgungseinheit enthält vorzugsweise eine Sekundärspule, einen nachgeschalteten Gleichrichter und einen Speicher, beispielsweise Kondensator zur Energiespeicherung. Die Energieversorgung des Näherungssensors aus dieser Energieversorgungseinheit erfolgt vorzugsweise gepulst mit vorgegebener Einschaltdauer und vorgegebener Ausschaltdauer, was den Vorteil der Optimierung bzw. der Reduktion, des Energiebedarfs hat. Eine zum Näherungssensor korrespondierende Basisstation enthält zweckmäßig einen Oszillator, der eine Primärspule mit einer mittelfrequenten Schwingung im Bereich von etwa 15 kHz bis 15 MHz speist, wodurch ein magnetisches Feld erzeugt wird. Die Sekundärspule der Energieversorgungseinheit empfängt dieses mittelfrequente magnetische Feld und realisiert die Wandlung von magnetischer in elektrische Energie.

Die angegebene Mittelfrequenz würde zur Abstrahlung von elektromagnetischen Feldern führen, deren Wellenlängen größer als 22 m bis 22 km sind und damit größer sind als die Abmessung der eingesetzten Primärwicklung, so daß die Primärwicklung aufgrund ihrer Abmessungen nicht als Antenne für derartige elektromagnetische Strahlung wirkt.

In Fig. 2 ist eine zweite Ausführungsform eines steckbaren Näherungssensors dargestellt. Der gezeigte Näherungssensor ist prinzipiell in gleicher Weise aufgebaut wie die vorstehend unter Fig. 1 erläuterte erste Ausführungsform, jedoch weist der eingesetzte Befestigungsabschnitt 3 einen größeren Durchmesser auf als der Befestigungsabschnitt 1 gemäß Fig. 1. Das Beispiel soll zeigen, daß alle erforderlichen Befestigungsabschnitte mit zylindrischem Gehäuse unterschiedlichen Durchmessers oder mit Gehäusen anderer Form realisiert werden können und in einfacher Weise mit dem universellen Elektronikabschnitt 2 verbindbar sind.

Die elektrische Verbindung zwischen den beiden Näherungssensor-Baukomponenten Befestigungsabschnitt 1 oder 3 und Elektronikabschnitt 2 erfolgt vorzugsweise über elektrische Steckkontakte, kann aber kontaktlos über eine magnetische Kopplung erfolgen, was den Vorteil einer höheren Zuverlässigkeit hat. Die Sensorsignal-Auswerteeinheit kann adaptiv den angeschlossenen Sensorkopf erkennen und die übermittelten Sensorsignale entsprechend auswerten. Zur Anpassung der Sensorsignal-Auswerteeinheit an den angeschlossenen Sensorkopf sind beispielsweise zusätzliche Kontakte bei der Verbindung der beiden Baukomponenten Befestigungsabschnitt 1 oder 3 und Elektronikabschnitt 2 vorgesehen.

Bei beschränktem Einbauraum kann zusätzlich ein Zwischenstück 4 zwischen Befestigungsabschnitt 1 oder 3 und Elektronikabschnitt 2 gefügt werden, wie es eine dritte Ausführungsform eines steckbaren Näherungssensors in Fig. 3 zeigt. Bei dieser Ausführungsform ist der Näherungssensor demnach aus drei miteinander verbindbaren Baukomponenten zusammengesetzt. Vorzugsweise erfolgen die elektrischen Verbindungen über Steckkontakte. Zweckmäßig ist das Zwischenstück 4 verformbar, so daß eine genaue Anpassung an den zur Verfügung stehenden Einbauraum möglich ist.

Die Erfindung kann insbesondere auch bei einem Industrieroboter, einem Fertigungsautomaten, einem Herstellungsautomaten oder einem Automationssystem verwendet werden, welcher bzw. welches eine Vielzahl von Näherungssensoren/Näherungsschaltern (System) mit unterschiedlichen Befestigungsöffnungen aufweist, wobei eine Funkübertragung zwischen den einzelnen Näherungssensoren und einer Zentralstation mit angeschlossenem Prozeßrechner zur Übermittlung der Sensorsignale und gegebenenfalls zur Übermittlung von Parametersätzen vorgesehen ist.

## Patentansprüche

1. Näherungssensor mit Sensorkopf zur Erzeugung von Sensorsignalen, wobei der Näherungsensor aufgeteilt ist in einen den Sensorkopf enthaltenden Befestigungsabschnitt (1, 3) und in einen hiermit verbindbaren Elektronikabschnitt (2), welcher zumindest eine Sensorsignal-Auswerteeinheit und eine Energieversorgung aufweist, wobei die Sensorsignale über elektrische Kontakte oder kontaktlos vom Befestigungsabschnitt (1, 3) zum Elektronikabschnitt (2) gelangen, **dadurch gekennzeichnet, daß** der Elektronikabschnitt (2) zusätzlich einen Modulator/Codierer mit nachgeordnetem Funksender und Antenne zur Abstrahlung von Sensorsignalen sowie einen Funkempfänger mit nachgeordnetem Demodulator/Decodierer zum Funkempfang von Parametersätzen aufweist.

2. Näherungssensor nach Anspruch 1, **dadurch gekennzeichnet, daß** die Energieversorgungseinheit eine Sekundärspule, einen nachgeschalteten Gleichrichter und einen Speicher enthält, wobei die Sekundärspule ein mittelfrequentes magnetisches Feld empfängt und die Wandlung von magnetischer in elektrische Energie realisiert.

3. Näherungssensor nach Anspruch 1 oder 2, **dadurch gekennzeichnet, daß** der Befestigungsabschnitt (1, 3) ein zum Eingriff in eine Maschinenkomponente geeignetes Gewinde aufweist.

4. Näherungssensor nach einem der vorstehenden Ansprüche, **dadurch gekennzeichnet, daß** die elektrische Verbindung zwischen Befestigungsabschnitt (1, 3) und Elektronikabschnitt (2) über Steckkontakte erfolgt.

5. Näherungssensor nach einem der Ansprüche 1 bis 3, **dadurch gekennzeichnet, daß** die elektrische Verbindung zwischen Befestigungsabschnitt (1, 3) und Elektronikabschnitt (2) über eine magnetische Kopplung erfolgt.

6. Näherungssensor nach einem der vorstehenden Ansprüche, **dadurch gekennzeichnet, daß** die elektrische Verbindung zwischen Befestigungsabschnitt (1, 3) und Elektronikabschnitt (2) über ein zusätzliches Zwischenstück (4) erfolgt.

7. Näherungssensor nach Anspruch 6, **dadurch gekennzeichnet, daß** das Zwischenstück verformbar ausgebildet ist.

8. Näherungssensor nach einem der vorstehenden Ansprüche, **dadurch gekennzeichnet, daß** die Sensorsignal-Auswerteeinheit den angeschlossenen Sensorkopf adaptiv erkennt, um die Sensorsignale dementsprechend auszuwerten.

## Claims

1. A proximity sensor with a sensor head for generating sensor signals, with the proximity sensor being divided into a fastening section (1, 3) containing the sensor head and an electronic section (2) which can be connected with the same and which comprises at least one sensor signal evaluation unit and a power supply, with the sensor signals reaching via electric contacts or in a contactless manner from the fastening section (1, 3) to the electronic section (2), **characterized in that** the electronic section (2) additionally comprises a modulator/encoder with downstream radio transmitter and antenna for emitting sensor signals and a radio receiver with downstream demodulator/decoder for radio reception of parameter records.

2. A proximity sensor according to claim 1, **characterized in that** the power supply unit comprises a secondary coil, a downstream rectifier and a storage, with the secondary coil receiving a medium-frequency magnetic field and realizing the conversion of magnetic into electric energy.

3. A proximity sensor according to claim 1 or 2, **characterized in that** the fastening section (1, 3) comprises a thread suitable for engagement in a machine component.

4. A proximity sensor according to one of the preceding claims, **characterized in that** the electric connection between fastening section (1, 3) and electronic section (2) is made via plug-in contacts.

5. A proximity sensor according to one of the claims 1 to 3, **characterized in that** the electric connection between fastening section (1, 3) and electronic section (2) is made via magnetic coupling.

6. A proximity sensor according to one of the preceding claims, **characterized in that** the electric connection between fastening section (1, 3) and the electronic section (2) is made via an additional intermediate element (4).

7. A proximity sensor according to claim 6, **characterized in that** the intermediate element is provided with a deformable configuration.

8. A proximity sensor according to one of the preceding claims, **characterized in that** the sensor signal evaluation unit recognizes the connected sensor head adaptively in order to evaluate the sensor signals accordingly.

## Revendications

1. Détecteur de proximité avec une tête pour produire des signaux, qui est divisé en une section de fixation (1, 3) contenant la tête de détecteur et une section d'électronique (2) qui peut être reliées à la précédente et qui comporte au moins une unité d'évaluation des signaux du détecteur et une alimentation en énergie, les signaux du détecteur étant transmis de la section de fixation (1, 3) à la section d'électronique (2) par l'intermédiaire de contacts électriques ou sans contact, **caractérisé en ce que** la section d'électronique (2) présente en plus d'un modulateur/codeur avec en aval de celui-ci un émetteur radio et une antenne pour envoyer par radio des signaux du détecteur, un récepteur radio avec en aval de celui-ci, un démodulateur/décodeur pour recevoir par radio des séries de paramètres.

2. Détecteur de proximité selon la revendication 1, **caractérisé en ce que** l'unité d'alimentation en énergie contient une bobine secondaire, un redresseur monté en aval et une mémoire, la bobine secondaire recevant un champ magnétique à fréquence moyenne et transformant ce champ en énergie électrique..

3. Détecteur de proximité selon la revendication 1 ou 2, **caractérisé en ce que** la section de fixation (1, 3) présente un filetage pour venir en prise avec un composant de machine.

4. Détecteur de proximité selon une des revendications 1 à 3, **caractérisé en ce que** la liaison électrique entre la section de fixation (1, 3) et la section d'électronique (2) est assurée par des contacts enfichables..

5. Détecteur de proximité selon une des revendications 1 à 3, **caractérisé en ce que** la liaison électrique entre la section de fixation (1, 3) et la section d'électronique (2) est assurée par un couplage magnétique.

6. Détecteur de proximité selon une des revendications précédentes, **caractérisé en ce que** la liaison électrique entre la section de fixation (1, 3) et la section d'électronique (2) est assurée par une pièce intermédiaire (4) supplémentaire.

7. Détecteur de proximité selon la revendication 6, **caractérisé en ce que** la pièce intermédiaire est déformable.

8. Détecteur de proximité selon une des revendications précédentes, **caractérisé en ce que** l'unité d'évaluation des signaux du détecteur reconnaît de manière adaptative la tête du détecteur raccordée, de manière à évaluer de manière correspondante les signaux du détecteur.
